# EUROPEAN PATENT SPECIFICATION

(11) **EP 2 194 030 B1**
(45) Date of publication and mention of the grant of the patent: **27.12.2017**
(21) Application number: 08791510.4
(22) Date of filing: 24.07.2008
(51) Int. Cl.: C03B 19/01, C03C 3/06

(54) **USE OF A QUARTZ GLASS MEMBER FOR PLASMA ETCHING**
VERWENDUNG EINES QUARZGLASELEMENTS FÜR DAS PLASMAÄTZEN
UTILISATION D'UN ELÉMENT DE VERRE QUARTZEUX POUR UNE GRAVURE AU PLASMA

(30) Priority: 02.08.2007 JP 2007201753
(43) Date of publication of application: 09.06.2010
(73) Proprietor: Shin-Etsu Quartz Products Co., Ltd., Shinjuku-ku Tokyo 160-0023 (JP); Heraeus Quarzglas GmbH & Co. KG, 63450 Hanau (DE)
(72) Inventor: SATO, Tatsuhiro, Koriyama-shi Fukushima 963-0725 (JP); INAKI, Kyoichi, Tokyo 160-0023 (JP)
(74) Representative: Staudt, Armin Walter
(86) International application number: PCT/JP2008/063258
(87) International publication number: WO 2009/017020

(56) References cited:
- EP-A1- 1 471 039
- EP-A2- 0 742 578
- WO-A1-2006/038349
- JP-A- 2002 220 257
- JP-A- 2002 220 257
- JP-A- 2002 356 337
- JP-A- 2002 356 345
- JP-A- 2002 356 346
- JP-A- 2004 284 828
- JP-A- 2004 323 246
- JP-A- 2005 336 011

## Description

### Technical Field

The present invention relates to the use of a doped quartz glass member for plasma etching for production of a semiconductor, and has excellent plasma corrosion resistance.

### Background Art

In the production of the semiconductor, for example, in the production of a semiconductor wafer, in accordance with a recent trend in increasing a diameter thereof, an improvement of treatment efficiency is performed by using a plasma reaction apparatus in an etching process and the like. For example, in a process of etching the semiconductor wafer, an etching treatment is performed by using a plasma gas such as a fluorine (F-)based plasma gas.
However, when the conventional quartz glass is placed in an F-based plasma gas atmosphere, for example, SiO₂ and the F-based plasma gas are allowed to react with each other on a surface of the quartz glass, to thereby generate SiF₄. The thus generated SiF₄ has a boiling point of -86°C, and hence is easily sublimated, and the quartz glass is corroded to a great extent, causing a reduction in thickness or roughening of the surface to progress. Thus, the quartz glass was found to be unsuitable for use as a jig in an atmosphere of the F-based plasma gas. As described above, in the conventional quartz glass, a serious problem was generated in corrosion resistance, namely, plasma corrosion resistance, in a plasma reaction at the time of producing semiconductor, particularly, an etching treatment using the F-based plasma gas.

Consequently, there is proposed a method of producing doped quartz glass in which the following are doped in quartz glass: one kind of a first metal element selected from metal elements belonging to Group 3B of the periodic table; and at least one kind of a second metal element selected from the group consisting of Mg, Ca, Sr, Ba, Sc, Y, Ti, Zr, Hf, lanthanoids, and actinoids (for example, refer to Patent Document JP 2002-220257 A). According to the method, boiling point of fluorides of the metal elements is high. Therefore a large amount of SiF₄ portion is corroded, while, in a portion of the fluorides of the metal elements, the amount of sublimation from the surface is small. As a result, it is presumed that the difference between the etching amounts is increased. When the plasma corrosion resistance is investigated, because the boiling point of, for example, NdF₃ is 2,327°C, the etching rate of the doped quartz glass is lower by 50% to 70% compared with that of the quartz glass member which is not at all doped with a metal element.

### Disclosure of the Invention

### Problem to be solved by the Invention

In the doped quartz glass produced by the above-mentioned conventional production method, the plasma corrosion resistance increases, but fluorides such as AlF₃, NdF₃, and YF₃ are accumulated to a great extent on the surface of the quartz glass, and when regular cleaning and removing is neglected, the fluorides fly apart as fine particles during use. As a result, the amount of doped quartz glass having a defect in terms of the semiconductor properties has increased, and the acceptance yield has decreased.

The present invention has been achieved in view of the above-mentioned problem with the background art, and an object of the present invention is to use a doped quartz glass member for plasma etching process and is free from any problematic fluoride accumulation during use.

### Means for solving the Problem

The inventors of the present invention have intensively studied and as a result, the inventors have found that the above-mentioned problem can be solved by maintaining the total amount of the metal element concentration with which a doped quartz glass member is doped at 0.01 wt% or more to less than 0.1 wt%. In addition, the inventors have also found that at least one kind of metal element selected from metal elements belonging to Group 3B of the periodic table and at least one kind of metal element selected from the group consisting of Mg, Ca, Sr, Ba, Sc, Y, Ti, Zr, Hf, lanthanoids, and actinoids can be suitably used as the metals with which a doped quartz glass part is doped. The present invention used as a quartz glass member as a jig for semiconductor production in a plasma etching process, includes at least two or more kinds of doping metal elements in a total amount of 0.01 wt% or more to less than 0.1 wt%, in which the metal elements are formed of at least one kind of a first metal element selected from metal elements belonging to Group 3B of the periodic table and at least one kind of a second metal element selected from the group consisting of Mg, Ca, Sr, Ba, Sc, Y, Ti, Zr, Hf, lanthanoids, and actinoids.

It is preferred that a blend ratio of the first metal element (M1) to the second metal element (M2) be in a range of 0.1 to 10 in terms of a weight ratio of (M1)/(M2).

In the quartz glass member for plasma etching the thickness from the surface thereof to a predetermined depth is preferably formed of a metal element-containing layer containing 0.01 wt% or more to less than 0.1 wt% of the metal elements. The thickness of the metal element-containing layer is preferably at least 5 mm.

### Function

When a plasma gas of CF₄ is attached to the surface of quartz glass, SiF₄ is generated, and when the gas is reacted with doping metals such as Al and Y, AlF₃ and YF₃ are generated, respectively. As mentioned above, SiF₄ volatilizes, and AlF₃, YF₃, and the like remain on the surface. The amount of the remained compounds depends on the amount of the CF₄ gas as a reactive factor and on the amount of the metal elements doped in the quartz glass in the quartz glass side.

That is, when the amount of the doping metal elements is decreased, the accumulation amount of the fluorides may decrease. As a result of various studies, it has been found that when the total amount of the doping metal element concentration is 0.01 wt% or more to less than 0.1 wt%, the amount of the accumulated fluorides has achieved a level that is not problematic under all plasma etching conditions.

### Result of the Invention

The quartz glass member for plasma etching of the present invention has the excellent plasma corrosion resistance, in particular, the excellent corrosion resistance to an F-based plasma gas, and is free from the fluoride accumulation on the surface thereof, thereby being capable of being used for a long period of time, without causing defects in silicon wafer properties due to the fluorides flying apart as particles.

### Brief Description of the Drawings

- FIG. 1: is a photograph showing a surface exposed to a plasma gas of a quartz glass disk produced in Example 1.
- FIG. 2: is a photograph showing a surface exposed to a plasma gas of a quartz glass disk produced in Comparative Example 1.
- FIG. 3: is a photograph showing a surface exposed to a plasma gas of a quartz glass disk produced in Comparative Example 2.

### Best Mode for carrying out the Invention

Subsequently, an embodiment of a quartz glass member for plasma etching is described, but the embodiment is merely described as an example. The use of a quartz glass member as a jig for semiconductor production in a plasma etching process, includes at least two or more kinds of doping metal elements in a total amount of 0.01 wt% or more to less than 0.1 wt%, and a main point is that the metal elements are formed of at least one kind of a first metal element selected from metal elements belonging to Group 3B of the periodic table and at least one kind of a second metal element selected from the group consisting of Mg, Ca, Sr, Ba, Sc, Y, Ti, Zr, Hf, lanthanoids, and actinoids.

The first and second metal elements contained in the quartz glass member of the present invention each have a higher boiling point when formed into a fluoride compared with Si, and hence, etching is not performed. For example, the boiling point of SmF is 2,427°C.

It should be noted that, when one of those metal elements is contained singly, white turbidity may occur in the quartz glass member, or a large amount of bubbles and foreign matter are generated even when the quartz glass member is made transparent. The cause of the white turbidity is in that each metal element is present in the quartz glass member as an agglomerate of an oxide having a different refractive index from that of SiO₂ and scatters light at an interface with SiO₂. The cause of the bubbles and the foreign matter is also in the maldistribution of oxides thereof in large agglomerates.

Of those metal elements, in particular, Mg, Ca, Sr, Ba, Sc, Y, Ti, Zr, Hf, lanthanoids, actinoids, and the like, which are the second metal elements, carry positive charges in the quartz glass member and are easily formed into oxides, so the degree of light scattering is high.

Accordingly, when the second metal element is contained not singly but together with at least one kind of the first metal element selected from metal elements belonging to Group 3B of the periodic table, the first metal element is incorporated into a quartz network and generates a negative charge, and hence, the first metal element and the second metal element retaining a positive charge draw each other and offset each other's charges, so the metal elements are prevented from being formed into oxides and being agglomerated. An example of the metal element selected from metal elements belonging to Group 3B of the periodic table includes Al, and Al is most preferred as the first metal element, because Al is an element which is not particularly problematic in a semiconductor production process. Further, as the second metal element, Y, Nd, or Sm is suitable.

The total sum of the concentration of the contained metal element is 0.01 wt% or more to less than 0.1 wt%. When the total sum is less than 0.01 wt%, a significant improvement in plasma corrosion resistance cannot be confirmed, and when the total sum is 0.1 wt% or more, the plasma corrosion resistance becomes excellent, but the fluorides of the contained metals accumulate and a semiconductor yield decreases.

It is preferred that a blend ratio of the first metal element (M1) to the second metal element (M2) be in a range of 0.1 to 10 in terms of a weight ratio of (M1)/(M2). When the blend ratio is less than 0.1, a large amount of white foreign matters may be generated, and when the blend ratio exceeds 10, a large amount of bubbles may be generated.

### Examples

Hereinafter, the present invention is described in more detail by way of examples, but those examples are merely illustrative and it goes without saying that the examples are not to be construed as limiting.

### (Example 1)

9,985 g of natural quartz glass powder and doping raw material powder produced by mixing 11.3 g of Al₂O₃ and 3.8 g of Y₂O₃ were introduced into oxyhydrogen flame, to thereby produce an ingot having a diameter of 350 mm and a thickness of 45 mm. The glass body was processed to thereby produce a quartz glass disk having a diameter of 300 mm and a thickness of 5 mm. The doping metal element concentration of the ingot was determined by X-ray analysis, and the concentrations of Al and Y were 0.06 wt% and 0.03 wt%, respectively.

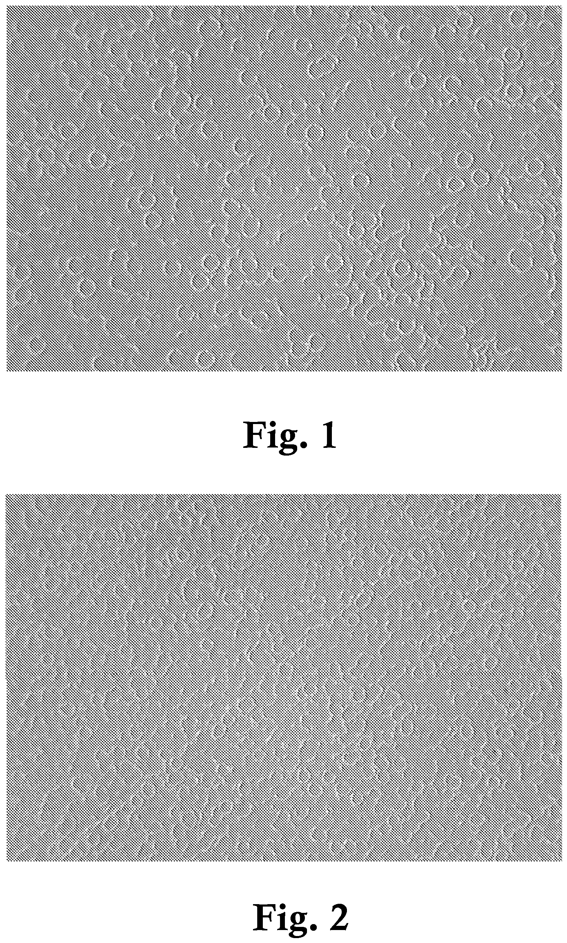

The obtained quartz glass disk was used as a quartz glass window of an ICP plasma dry etching apparatus, and an etching test was performed by pouring 50 sccm of a CF₄+O₂ (20%) plasma gas and letting the plasma gas run the quartz glass disk at 30 mtorr and 0.5 kw for 300 hours. The etching rate was calculated from the change in thickness before and after the test, and the result revealed that the etching rate at the vicinity of the center of the disk, where etching proceeded the most, was 60 nm/min. This corresponded to a depletion thickness of 1.04 mm. The mechanical strength of the quartz glass disk was still sufficient and the continuous use thereof was possible. As shown in the photograph of FIG. 1, there was no accumulation of fluorides, which were to be causes of particles, on a surface exposed to a plasma gas of the quartz glass disk.

### (Example 2)

9,992 g of natural quartz glass powder and doping raw material powder produced by mixing 5.7 g of Al₂O₃ and 1.9 g of Y₂O₃ were introduced into oxyhydrogen flame, to thereby produce an ingot having a diameter of 350 mm and a thickness of 45 mm. The glass body was processed to thereby produce a quartz glass disk having a diameter of 300 mm and a thickness of 5 mm. The doping metal element concentration of the ingot was determined by X-ray analysis, and the concentrations of Al and Y were 0.03 wt% and 0.015 wt%, respectively.

The obtained quartz glass disk was used as a quartz glass window of an ICP plasma dry etching apparatus, and an etching test was performed by pouring 50 sccm of a CF₄+O₂ (20%) plasma gas and letting the plasma gas run the quartz glass disk at 30 mtorr and 0.5 kw for 300 hours. The etching rate was calculated from the change in thickness before and after the test, and the result revealed that the etching rate at the vicinity of the center of the disk, where etching proceeded the most, was 70 nm/min. This corresponded to a depletion thickness of 1.26 mm. The mechanical strength of the quartz glass disk was still sufficient and the continuous use thereof was possible. There was no accumulation of fluorides, which were to be causes of particles, on a surface exposed to a plasma gas of the quartz glass disk.

### (Example 3)

9,997.5 g of natural quartz glass powder and doping raw material powder produced by mixing 1.9 g of Al₂O₃ and 0.6 g of Y₂O₃ were introduced into oxyhydrogen flame, to thereby produce an ingot having a diameter of 350 mm and a thickness of 45 mm. The glass body was processed to thereby produce a quartz glass disk having a diameter of 300 mm and a thickness of 5 mm. The doping metal element concentration of the ingot was determined by X-ray analysis, and the concentrations of Al and Y were 0.01 wt% and 0.005 wt%, respectively.

The quartz glass disk was used and an etching test was performed in the same manner as in Example 1. The etching rate was calculated from the change in thickness before and after the test, and the result revealed that the etching rate at the vicinity of the center of the disk, where etching proceeded the most, was 80 nm/min. This corresponded to a depletion thickness of 1.44 mm. The mechanical strength of the quartz glass disk was still sufficient and the continuous use thereof was possible. There was no accumulation of fluorides, which were to be causes of particles, on a surface exposed to a plasma gas of the quartz glass disk.

### (Example 4)

9,992.6 g of natural quartz glass powder and doping raw material powder produced by mixing 5.7 g of Al₂O₃ and 1.8 g of Nd₂O₃ were introduced into oxyhydrogen flame, to thereby produce an ingot having a diameter of 350 mm and a thickness of 45 mm. The glass body was processed to thereby produce a quartz glass disk having a diameter of 300 mm and a thickness of 5 mm. The doping metal element concentration of the ingot was determined by X-ray analysis, and the concentrations of Al and Nd were 0.03 wt% and 0.015 wt%, respectively.

The quartz glass disk was used and an etching test was performed in the same manner as in Example 1. The etching rate was calculated from the change in thickness before and after the test, and the result revealed that the etching rate at the vicinity of the center of the disk, where etching proceeded the most, was 70 nm/min. This corresponded to a depletion thickness of 1.26 mm. The mechanical strength of the quartz glass disk was still sufficient and the continuous use thereof was possible. There was no accumulation of fluorides, which were to be causes of particles, on a surface exposed to a plasma gas of the quartz glass disk.

### (Comparative Example 1)

10,000 g of natural quartz glass powder were introduced into oxyhydrogen flame, to thereby produce an ingot having a diameter of 350 mm and a thickness of 45 mm. The glass body was processed to thereby produce a quartz glass disk having a diameter of 300 mm and a thickness of 5 mm. The doping metal element concentration of the ingot was determined by X-ray analysis, and the concentrations of Al and Y were 0.00 wt% and 0.00 wt%, respectively.

The quartz glass disk was used and an etching test was performed in the same manner as in Example 1. The etching rate was calculated from the change in thickness before and after the test, and the result revealed that the etching rate at the vicinity of the center of the disk, where etching proceeded the most, was 100 nm/min. This corresponded to a depletion thickness of 1.8 mm. The mechanical strength of the quartz glass disk deteriorated due to the reduced thickness and the quartz glass disk could not be used any more. As shown in the photograph of FIG. 2, there was no accumulation of fluorides, which were to be causes of particles, on a surface exposed to a plasma gas of the quartz glass disk.

### (Comparative Example 2)

9,975 g of natural quartz glass powder and doping raw material powder produced by mixing 18.9 g of Al₂O₃ and 6.3 g of Y₂O₃ were introduced into oxyhydrogen flame, to thereby produce an ingot having a diameter of 350 mm and a thickness of 45 mm. The glass body was processed to thereby produce a quartz glass disk having a diameter of 300 mm and a thickness of 5 mm. The doping metal concentration of the ingot was determined by X-ray analysis, and the concentrations of Al and Y were 0.10 wt% and 0.05 wt%, respectively.

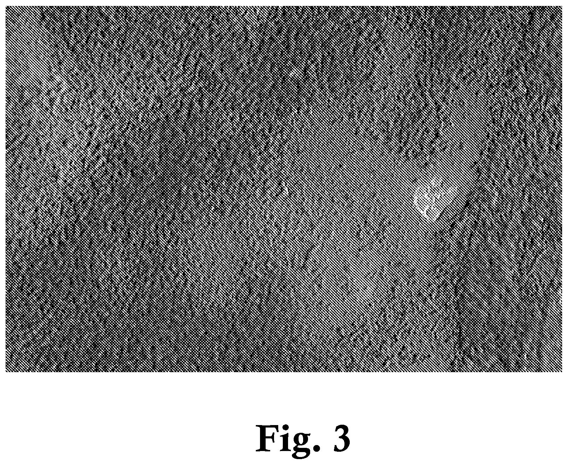

The quartz glass disk was used and an etching test was performed in the same manner as in Example 1. The etching rate was calculated from the change in thickness before and after the test, and the result revealed that the etching rate at the vicinity of the center of the disk, where etching proceeded the most, was 30 nm/min. This corresponded to a depletion thickness of 0.54 mm. The mechanical strength of the quartz glass disk was still sufficient and the continuous use thereof was possible. However, as shown in the photograph of FIG. 3, the accumulation of a large amount of fluorides, which were to be causes of particles, was generated on a surface exposed to a plasma gas of the quartz glass disk, and the fluorides flew apart on a silicon wafer. Thus, the silicon wafer was rendered unusable.

Table 1 collectively shows the kind and the concentration of the element of each of the first and second metal elements used in each of Examples 1 to 4 and Comparative Examples 1 and 2, the etching rate, the depletion thickness, and the evaluations on the plasma exposed surface of each of the produced quartz glass members.

**Table 1**

| | First doping metal element | | Second doping metal element | | Etching | Depletion thickness | Plasma |
|---|---|---|---|---|---|---|---|
| | Kind of element | Concentr ation | Kind of element | Concentration | Rate | Thickness | Exposed surface |
| | | (wt%) | | (wt%) | (nm/min) | (mm) | Accumu -lation |
| Example 1 | Al | 0.06 | Y | 0.030 | 60 | 1.04 | Absent |
| Example 2 | Al | 0.03 | Y | 0.015 | 70 | 1.26 | Absent |
| Example 3 | Al | 0.01 | Y | 0.005 | 80 | 1.44 | Absent |
| Example 4 | Al | 0.03 | Nd | 0.015 | 70 | 1.26 | Absent |
| Comparative Example 1 | - | 0.00 | - | 0.000 | 100 | 1.80 | Absent |
| Comparative Example 2 | Al | 0.100 | Y | 0.05 | 30 | 0.54 | Present |

## Claims

1. Use of a quartz glass member, comprising at least two or more kinds of doping metal elements in a total amount of 0.01 wt% or more to less than 0.1 wt%, wherein the metal elements are formed of at least one kind of a first metal element selected from metal elements belonging to Group 3B of the periodic table and at least one kind of a second metal element selected from the group consisting of Mg, Ca, Sr, Ba, Sc, Y, Ti, Zr, Hf, lanthanoids, and actinoids for avoiding fluoride accumulation during use in a plasma etching process for semiconductor production.

2. Use of a quartz glass member according to claim 1, wherein a blend ratio of the first metal element (M1) to the second metal element (M2) is in a range of 0.1 to 10 in terms of a weight ratio of (M1)/(M2).

3. Use of a quartz glass member according to claim 1 or 2, wherein a thickness from a surface to a predetermined depth of the quartz glass member is formed of a metal element-containing layer containing 0.01 wt% or more to less than 0.1 wt% of the metal elements.

## Patentansprüche

1. Verwendung eines Quarzglas-Bauteils, das mindestens zwei oder mehr Arten von Metallelementen als Dotierstoff in einem Gesamtmenge von mindestens 0,01 Gew.-% und weniger als 0,1 Gew.-% enthält, wobei die Metallelemente mindestens eine Art eines ersten Metallelements, ausgewählt aus den zur Gruppe 3b des Periodensystems gehörenden Metallelementen, und mindestens eine Art eines zweiten Metallelements, ausgewählt aus der Gruppe bestehend aus Mg Ca, Sr, Ba, Sc, Y, Ti, Zr, Hf, Lanthanoide und Actinoide umfassen, zum Zweck der Vermeidung von Fluorid- Akkumulation beim Einsatz in einem Plasma Ätzprozess bei der Halbleiterfertigung.

2. Verwendung eines Quarzglas-Bauteils nach Anspruch 1, wobei ein Mischungsverhältnis zwischen dem ersten Metallelement (M1) und dem zweiten Metallelement (M2), bezogen auf das Gewichtsverhältnis (M1)/(M2), im Bereich von 0,1 bis 10 liegt.

3. Verwendung eines Quarzglas-Bauteils nach Anspruch 1 oder 2, wobei ein Bereich von einer Oberfläche bis zu einer vorgegebenen Tiefe des Quarzglas-Bauteils von einer Metallelement enthaltenden Schicht gebildet ist, die mindestens 0,01 Gew.-% und weniger als 0,1 Gew.-% Metallelemente enthält.

## Revendications

1. Utilisation d'un élément en verre de quartz, comprenant au moins deux, ou davantage, éléments métalliques de dopage en une quantité totale supérieure ou égale à 0,01 % et inférieure à 0,1 % en poids, dans laquelle les éléments métalliques sont formés d'au moins un type d'un premier élément métallique sélectionné parmi des éléments métalliques appartenant au groupe 3B du tableau périodique et au moins un type d'un second élément métallique sélectionné parmi le groupe consistant en Mg, Ca, Sr, Ba, Sc, Y, Ti, Zr, Hf, les lanthanides, et des actinides pour éviter une accumulation du fluorure durant l'utilisation dans un processus de gravure par plasma pour la production de semi-conducteurs.

2. Utilisation d'un élément en verre de quartz selon la revendication 1, dans laquelle un rapport de mélange du premier élément métallique (M1) au second élément métallique (M2) est compris dans une plage de 0,1 à 10, en termes d'un rapport de poids de (M1)/(M2).

3. Utilisation d'un élément en verre de quartz selon la revendication 1 ou 2, dans laquelle une épaisseur à partir d'une surface jusqu'à une profondeur prédéterminée de l'élément en verre de quartz est formée d'une couche contenant un élément métallique d'une teneur supérieure ou égale à 0,01 % en poids et inférieure à 0,1 % en poids des éléments métalliques.
